Europäisches Patentamt

European Patent Office

Office européen des brevets

(19)

(11) Veröffentlichungsnummer: **0 071 881**
**B1**

(12)

# EUROPÄISCHE PATENTSCHRIFT

(45) Veröffentlichungstag der Patentschrift:
05.02.86

(51) Int. Cl.⁴: **G 03 F 7/08**, G 03 C 1/54,
G 03 C 1/70, G 03 C 5/34

(21) Anmeldenummer: **82106814.5**

(22) Anmeldetag: **28.07.82**

(54) Verfahren zur Herstellung von Flachdruckformen aus einem lichtempfindlichen Material auf Basis von Diazoniumsalz-Polykondensationsprodukten.

(30) Priorität: **05.08.81 DE 3130987**

(43) Veröffentlichungstag der Anmeldung:
**16.02.83 Patentblatt 83/7**

(45) Bekanntmachung des Hinweises auf die Patenterteilung:
**05.02.86 Patentblatt 86/6**

(84) Benannte Vertragsstaaten:
**DE FR GB**

(56) Entgegenhaltungen:
**DE - A - 3 036 077**
**DE - C - 2 019 426**

(73) Patentinhaber: **HOECHST AKTIENGESELLSCHAFT,**
**Postfach 80 03 20, D-6230 Frankfurt am Main 80 (DE)**

(72) Erfinder: **Neubauer, Rudolf, Dr. T.I.S. Div. American Hoechst, 3070 Highway 22 West P.O. Box 3700, Somerville, N.J. 08876 (US)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Herstellung von Flachdruckformen aus einem lichtempfindlichen Kopiermaterial, das auf einem Schichtträger eine negativ arbeitende Schicht aufweist, die ein Diazoniumsalz-Polykondensationsprodukt enthält.

Für die Lösung des technischen Problems, hochleistungsfähige negativ-arbeitende Flachdruckplatten auf Basis von Diazoniumsalz-Polykondensationsprodukt herzustellen, wurden bis heute zwei mögliche Wege vorgeschlagen. Der eine befaßt sich mit der Verbesserung der Eigenschaften der lichtempfindlichen Diazoverbindung, der andere mit der Auffindung neuer, mitunter maßgeschneiderter Polymerer, die als Stützgerüst innerhalb der Schicht funktionieren und dieser ihre physikalischen Eigenschaften aufzwingen.

Während die bekannten lichtempfindlichen Diazoverbindungen, wie sie beispielsweise in den DE-OSen 20 24 242 und 20 24 244 vorgeschlagen wurden, schon einen hohen Qualitätsstand erreicht haben, gestaltet sich die Feineinstellung der Kopierschichten über die zugesetzten Polymeren äußerst schwierig. So besteht beispielsweise die Gefahr, daß bei hoher Beanspruchung, wie beim Kartondruck, die Abriebfestigkeit unzureichend ist, oder daß die Bildstellen durch Verlust der Oleophilie blind werden oder daß wegen mangelhafter Entwicklung Schleierbildung auftritt bzw. daß die verschiedenen Schichtbestandteile bei wechselnden Lagerbedingungen nicht miteinander verträglich sind.

So werden mit wäßrig entwickelbaren Schichten aus reinen Diazopolykondensaten, vor allen Dingen Kondensaten aus 4-Diazodiphenylaminen und Formaldehyd oder 4-Diazodiphenylaminderivaten und anderen kondensationsfähigen Verbindungen, keine sehr hohen Druckauflagen erreicht. In stärkerem Maße gilt dies noch für entsprechende mit reinem Wasser entwickelbare Schichten, wie sie z. B. in der DE-PS 11 60 733 (= US-PS 3 220 832) beschrieben sind.

In der DE-OS 14 47 957 (= GB-PS 1 110 017) werden vorsensibilisierte Flachdruckplatten beschrieben, deren lichtempfindliche Schicht Kondensationsprodukte aus Diphenylamindiazoniumsalzen mit Formaldehyd in Kombination mit alkalilöslichen Harzen, z. B. Copolymeren aus Styrol und Maleinsäureanhydrid, enthält. Auch diese Schichten werden mit Wasser entwickelt, ergeben aber nur eine begrenzte Druckauflage.

In der DE-OS 22 43 212 (= US-PS 3 877 948) sind lithographische Druckplatten beschrieben, die aus wasserlöslichem Alkylenoxidpolymeren mit hohem Molekulargewicht, einem Polycarbonsäureharz oder einer Polycarbonsäure, die ein Assoziat mit dem Alkylenoxidpolymeren bildet, und einem photosensibilisierenden Mittel bestehen. Als Polyarbonsäureharze können in dieser lichtempfindlichen Mischung unter anderem auch Styrol-MaleinsäureanhydridMischpolymerisate verwendet werden. Eine Entwicklung durch Auswaschen der unbelichteten Schichtbereiche erfolgt nicht. Auch hier ist die Druckauflage begrenzt, da naturgemäß die Hydrophilie der unbelichteten Hintergrundbereiche beim Lagern der Druckform am Licht allmählich verschwindet.

Grundsätzlich ist es vorzuziehen, die eingangs erwähnten Mischkondensationsprodukte aus Diazoniumsalzen und damit kondensationsfähigen Zweitkomponenten zu verwenden, wie sie in der DE-OS 20 24 244 (= US-PS 3 867 147) beschrieben werden, da diese gegenüber den Kondensationsprodukten aus Diazoniumsalzen und Formaldehyd eine höhere Lichtempfindlichkeit aufweisen und auch höhere Druckauflagen ermöglichen.

Die heute verwendeten, wirklich leistungsfähigen Negativdruckplatten auf Basis dieser Diazoniumsalz-Kondensationsprodukte enthalten alle solche polymeren Bindemittel, die bei der Entwicklung eine Behandlung mit sauren wäßrigen Lösungen unter Zusatz teilweise flüchtiger und stark riechender Lösemittel erfordern. Solche Druckplatten werden z. B. in der DE-OS 27 39 774 (= US-PS 4 186 017) beschrieben. Sie beinhalten als Bindemittel Polyurethane.

In der DE-AS 20 19 426 (= GB-PS 1 352 411) wird ein lichtempfindliches Gemisch und ein lichtempfindliches Kopiermaterial zur Herstellung ätzfester Schichten beschrieben. Als lichtempfindliche Substanzen werden Diazopolykondensate aus 4-Diazodiphenylaminen und kondensationsfähigen Verbindungen verwendet. Als polymeres Bindemittel wird ein Gemisch aus zwei Harzen beschrieben, von denen eines auch ein Styrol-MaleinsäureanhydridCopolymerisat sein kann. Zur Entwicklung dieser Gemische dienen ausschließlich größere Mengen organische Lösemittel enthaltende Entwickler.

In der älteren deutschen Patentanmeldung P 30 36 077.1 ist schließlich ein lichtempfindliches Gemisch aus den genannten Diazoniumsalz-Mischkondensationsprodukten und einem in wäßrigem Alkali löslichen Polymeren mit seitenständigen Sulfonylurethangruppen vorgeschlagen worden. Dieses Gemisch läßt sich mit wäßrigen alkalischen Lösungen ohne Zusatz von organischen Lösemitteln entwickeln.

Aufgabe der Erfindung war es somit, ein Verfahren zur Herstellung von Flachdruckformen zu ermöglichen, die in ihren Qualitätsanforderungen den Druckplatten entsprechen, die nur unter Zusatz von organischen Lösemitteln entwickelbar sind, welches aber dennoch mit rein wäßrig alkalischen Lösungen durchführbar ist.

Gegenstand der Erfindung ist ein Verfahren zur Herstellung einer Flachdruckform, bei dem ein lichtempfindliches Kopiermaterial aus einem zum Flachdruck geeigneten Schichtträger mit hydrophiler Oberfläche und einer negativ arbeitenden lichtempfindlichen Schicht, die als lichtempfindliche Verbindung ein Kondensationsprodukt aus wiederkehrenden Einheiten $A-N_2X$ und B enthält, die durch zweibindige, von einer kondensationsfähigen Carbonylverbindung abgeleitete Zwischenglieder verbunden sind, wobei die Einheiten $A-N_2X$ sich aus Verbindungen der allgemeinen Formel

$(R^1-R^3-)$ $R^2-N_2X$

ableiten und wobei

X das Anion der Diazoniumverbindung,

p eine ganze Zahl von 1 bis 3,

$R^1$ einen carbocyclischen oder heterocyclischen aromatischen Rest mit mindestens einer kondensationsfähigen Position,

$R^2$ eine Arylengruppe der Benzol- oder Naphthalinreihe, $R^3$ eine Einfachbindung oder eine der Gruppen:

$-(CH_2)$ $-NR^4-$,

$-O-(CH_2)_r-NR^4-$,

$-S-(CH_2)_r-NR^4-$,

$-S-CH_2-CO-NR^4-$,

$-O-R^5-O-$,

$-O-$,

$-S-$ oder

$-CO-NR^4$

bedeuten, worin

q eine Zahl von 0 bis 5,

r eine Zahl von 2 bis 5,

$R^4$ Wasserstoff, eine Alkylgruppe mit 1 bis 5C-Atomen, eine Aralkylgruppe mit 7 bis 12 C-Atomen oder eine Arylgruppe mit 6 bis 12 C-Atomen, und

$R^5$ eine Arylengruppe mit 6 bis 12 C-Atomen ist, und

B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeutet,

wobei das Kondensationsprodukt im Mittel 0,01 bis 50 Einheiten B je Einheit $A-N_2X$ enthält,

und als einziges Bindemittel ein Copolymeres aus Styrol und Maleinsäureanhydrid oder einem Partialester der Maleinsäure enthält, bildmäßig belichtet wird und die nicht belichteten Schichtbereiche mit einem Entwickler ausgewaschen werden. Das erfindungsgemäße Verfahren ist dadurch gekennzeichnet, daß der Entwickler eine alkalische Lösung ist, die als Lösemittel ausschließlich Wasser enthält.

Überraschenderweise ergeben nun diese Copolymeren aus Styrol und Maleinsäureanhydrid oder den Partialestern, normalerweise den Halbestern der Maleinsäure, entstanden durch Umsetzung von Maleinsäureanhydrid mit Alkoholen oder Phenolen, im Gemisch mit Diazomischkondensaten, besonders auf anodisierten Trägern, Druckplatten mit hervorragenden Eigenschaften. Die Flachdruckplatten sind mit wäßrig-alkalischen Tensidlösungen umweltfreundlich entwickelbar und besitzen trotzdem das bisher nur von Druckplatten, die nur mit organische Lösemittel enthaltenden Entwicklern verarbeitet werden können, bekannte Eigenschaftsbild, das insbesondere umfaßt eine sehr gute Auflösung, gute Lichtempfindlichkeit, hohe Auflagenstabilität auch unter harten Bedingungen, sehr gute Differenzierung und gute Haltbarkeit bei längerer Lagerung.

Bei den verwendeten Polymeren handelt es sich um Additionspolymere aus Styrol und Maleinsäureanhydrid, bzw. Styrol und Halbestern der Maleinsäure. Von Vorteil sind Molgewichte der Polymeren zwischen 1000 und 100 000, bevorzugt zwischen 5000 und 50 000.

Durch die Monomerenzusammensetzung wird die im Endprodukt erreichbare Säurezahl bestimmt. Günstig sind Säurezahlen zwischen 30 und 500, bevorzugt zwischen 60 und 300.

Dabei bewegt sich die Monomerenzusammensetzung zwischen 30 - 80 Gew.-%, bevorzugt 40 - 70 Gew.-%, Styrol und 20 - 70 Gew.-%, bevorzugt 30 - 60 Gew.-%, Maleinsäureanhydrid, bzw. den Partialestern der Maleinsäure, bezogen auf das Gesamtgewicht des Polymeren.

Als Alkoholkomponenten der Maleinsäurehalbestereinheiten können aliphatische oder aromatische, bevorzugt niedere aliphatische, Alkohole mit folgenden Summenformeln Verwendung finden:

$C_nH_{2n+1}OH$ mit n = 1 bis 30, vorzugsweise 1 bis 10, verzweigt oder linear

$Ar(CH_2)_mOH$ m = 0 bis 4

Ar = Aromatischer Rest, der auch noch weitere Substituenten tragen kann.

$R-O-(CH_2-CH_2O)_lH$ 1 = 1 bis 10, bevorzugt 1 bis 4,

R = aromatischer oder aliphatischer Rest.

Als Diazoniumsalz-Polykondensationsprodukte sind Mischkondensationsprodukte kondensationsfähiger aromatischer Diazoniumsalze, z. B. von Diphenylamin-4-diazoniumsalzen geeignet, die außer den Diazoniumsalzeinheiten noch andere, nicht lichtempfindliche Einheiten enthalten, die von kondensationsfähigen Verbindungen, insbesondere aromatischen Aminen, Phenolen, Thiophenolen, Phenolethern, aromatischen Thioethern, aromatischen Kohlenwasserstoffen, aromatischen Heterocyclen und organischen Säureamiden, abgeleitet sind. Diese Kondensationsprodukte sind in der DE-OS 20 24 244 beschrieben.

Die Diazoniumsalzeinheiten leiten sich bevorzugt von Verbindungen der Formel $(R^1-R^3-)_pR^2-N_2X$ ab, wobei

X das Anion der Diazoniumverbindung,

p eine ganze Zahl von 1 bis 3,

$R^1$ einen aromatischen Rest mit mindestens einer zur Kondensation mit aktiver Carbonylverbindung befähigten Position,

$R^2$ eine Phenylengruppe,

$R^3$ eine Einfachbindung oder eine der Gruppen:

$-(CH_2)_q-NR^4-$,

$-O-(CH_2)_r-NR^4-$,

-S-(CH$_2$)$_r$-NR$^4$-,
-S-CH$_2$CO-NR$^4$-,
-0-R$^5$-0-,
- 0-
- S - oder
-CO-NR$^4$
bedeuten, worin
q eine Zahl von 0 bis 5,
r eine Zahl von 2 bis 5,
R$^4$ Wasserstoff, eine Alkylgruppe mit 1 bis 5 C-Atomen,eine Aralkylgruppe mit 7 bis 12 C-Atomen oder eine Arylgruppe mit 6 bis 12 C-Atomen, und R$^5$ eine Arylengruppe mit 6 bis 12 C-Atomen ist.

Die für das erfindungsgemäße Verfahren verwendeten Gemische enthalten das Diazoniumsalz-Polykondensationsprodukt und das polymere Bindemittel im allgemeinen in Mengen von 5 bis 90, bevorzugt 10 bis 70 Gew.-% Diazoniumverbindung und 95 bis 10, hevrorzugt 90 bis 30 Gew.-% polymeres Bindemittel.

Als polymeres Bindemittel werden die beschriebenen Copolymeren aus Styrol und Maleinsäureanhydrid bzw. Styrol und Maleinsäurepartial- bzw. -halbestern verwendet. Vorzugsweise sind sie die einzigen in der Schicht enthaltenen polymeren Bindemittel.

Zur Stabilisierung des lichtempfindlichen Gemisches ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder p-Toluolsulfonsäure bevorzugt werden. Eine besonders gut geeignete Säure ist die Phosphorsäure.

Den Gemischen können ferner Weichmacher, Haftvermittler, Farhstoffe, Pigmente und Farbbildner zugesetzt werden.

Art und Menge dieser Zusätze richten sich nach dem für das lichtempfindliche Gemisch vorgesehenen Anwendungsgebiet. Dabei ist grundsätzlich zu beachten, daß die beigefügten Stoffe keinen übergroßen Anteil des für die Vernetzung notwendigen aktinischen Lichts absorbieren und dadurch die praktische Lichtempfindlichkeit herabsetzen.

Die lichtempfindlichen Gemische können ferner Farbstoffe und/oder Pigmente enthalten, die sowohl als Kontrastmittel als auch schichtverfestigend wirken können. In Frage kommende Farbstoffe sind beispielsweise in den USPatentschriften 3 218 167 und 3 884 693 angegeben. Besonders geeignet sind z. B. Viktoriareinblau FGA oder Rhodamin 6 GDN (C.I. 45160). Zur Erhöhung des Bildkontrastes nach dem Belichten können Metanilgelb (C.I. 13065), Methylorange (C.I. 13025) oder Phenylazodiphenylamin verwendet werden.

Im Rahmen der Erfindung wird folgende gewichtsmäßige Verteilung der wichtigsten Zusätze in dem lichtempfindlichen Gemisch bevorzugt, bezogen auf den Gehalt an nichtflüchtigen Bestandteilen, d. h. die Bestandteile der nach dem Verdampfen des Lösemittels erhaltenen festen lichtempfindlichen Schicht.

Styrol-Maleinsäurederivat-Polymerisat : 30 bis 90 %

Diazoniumsalz-Polykondensationsprodukt: 10 bis 70 %

Säure : 0 bis 10 %

Farbstoff oder Pigment : 0 bis 12 %

Belichtungskontrastgeber (Farbstoff) : 0 bis 5 %

Die Beschichtung des Trägermaterials erfolgt aus entsprechenden organischen Lösemitteln oder Lösemittelgemischen, und zwar durch Gießen, Sprühen oder Eintauchen.

Als Lösemittel sind Alkohole, Ketone, Ester, Ether und dergleichen geeignet. Als günstige Lösemittel haben sich dabei die Fartialether der Glykole oder der Ketoalkohole erwiesen, z. B. Ethylenglykolmonomethylether.

Als Schichtträger eignen sich z. B. Magnesium, Zink, Kupfer, m-echanisch, chemisch und elektrochemisch aufgerauhtes Aluminium, anodisiertes Aluminium, Stahl, aber auch Polyester- oder Celluloseacetatfolie, Perlongaze etc., deren Oberfläche bei Bedarf einer Vorbehandlung unterworfen sein kann. Das Trägermaterial kann dabei als endgültiger Schichtträger fungieren oder als temporäres Trägermaterial, von dem die lichtempfindliche Schicht auf das zu bearbeitende Werkstück mittels Laminieren übertragen wird.

Das mit den lichtempfindlichen Gemischen hergestellte Aufzeichnungsmaterial dient einerseits zur Herstellung von Bildern auf geeigneten Trägern bzw. Empfangsblättern, andererseits zur Herstellung von Reliefs, die als Druckformen, Siebe, Reservagen und dgl. Anwendung finden.

Darüber hinaus ist es aber auch möglich, die lichtempfindlichen Gemische zur Herstellung von durch UV-Strahlung härtbaren Lacken zu verwenden, die als Oberflächenschutz eingesetzt werden können, oder zur Formulierung von UVhärtbaren Druckfarben.

Besonders bevorzugt wird das Gemisch zur Herstellung von Flachdruckformen verwendet, wobei als Trägermaterial Aluminium bevorzugt wird.

Besonders bevorzugt wird Aluminium, das für diesen Zweck in üblicher Weise vorbehandelt wird, z. B. durch mechanisches, chemisches oder elektrochemisches Aufrauhen und ggf. anschließende anodische Oxidation. Eine weitere Behandlung dieses Trägermaterials, z. B. mit Folyvinvlphosphonsäure, Alkalisilikat, Fhosphat, Hexafluorzirkonat, Chromat, Borat, Folyacrylamid und Cellulosederivaten, ist vorteilhaft.

Die Verarbeitung der aus den Gemischen erhaltenen Kopiermaterialien erfolgt in bekannter Weise durch bildmäßiges Belichten und Auswaschen der unbelichteten Schichtbereiche mit einem geeigneten Entwickler.

Die Belichtung des Kopiermaterials erfolgt in bekannter Weise unter einer Vorlage mit Kopierlichtquellen, die einen möglichst hohen Spektralanteil im nahen Ultraviolettbereich emittieren. Sie kann auch durch Laserbestrahlung erfolgen. Geeignet für die Bestrahlung sind leistungsgerechte kürzerwellige Laser, beispielsweise Ar-Laser, Krypton-Ionen-Laser, Helium/Cadmium-Laser, die etwa zwischen 300 und 600 nm emittieren, aber für einige Schichten auch $CO_2$-Laser, welche bei 10,6 μm emittieren, oder YAG-Laser, die bei 1,06 μm emittieren.

Als Entwicklerlösungen werden wäßrigalkalische Lösungen mit einem pH-Wert im Bereich von 8 bis 14, vorzugsweise 10 bis 13, verwendet, die Fuffersalze, z. B. wasserlösliche Alkaliphosphate, -silikate, -borate, -carbonate, -acetate oder -benzoate, enthalten. Als weitere Bestandteile werden Netzmittel, vorzugsweise anionische Netzmittel, und ggf. wasserlösliche Folymere, aber keine flüchtigen organischen Bestandteile verwendet.

Die Entwicklung kann in bekannter Weise durch Tauchen, Besprühen, Bürsten oder Tamponieren erfolgen.

Es ist überraschend, daß die schon lange bekannten Copolymeren aus Styrol und Maleinsäureanhydrid bzw. Halbestern der Maleinsäure in den erfindungsgemäß hergestellten Druckplatten eine leichte Entwicklung mit wäßrig-alkalischen, von organischen Lösemitteln freien Lösungen bei guter Lichtempfindlichkeit und hohen Druckauflagen ermöglichen. Im Gegensatz zu Druckplatten mit anderen Carboxylgruppen enthaltenden Bindemitteln entspricht das Eigenschaftsbild der erfindungsgemäß hergestellten Druckplatten solchen, die bisher nur mit organische Lösemittel enthaltenden Entwicklern entwickelt werden konnten.

Insbesondere weisen sie hohe praktische Lichtempfindlichkeit, hohes Auflösevermögen, leichte und schleierfreie Entwickelbarkeit, gute Lagerbeständigkeit, scharfe Differenzierung zwischen Bild- und Nichtbildstellen, hohe Druckauflagen und gute Verträglichkeit der Schichtbestandteile in den zur Beschichtung geeigneten Lösemitteln auf.

Die folgenden Beispiele sollen die Erfindung erläutern. Gewichtsteile und Volumteile stehen im Verhältnis von g/ccm, Frozentangaben und Mengenverhältnisse sind in Gewichtseinheiten zu verstehen, wenn nichts anderes angegeben ist.

**Beispiel 1**

Eine Beschichtungslösung wurde aus folgenden Komponenten hergestellt:
20,0 Gew.-Teile eines Styrol-Maleinsäureester-Copolymeren, Erweichungspunkt 160-175°C, Säurezahl 145-160,
10,0 '' eines Diazomischkondensates, hergestellt durch Kondensieren von 1 Mol 3-Methoxy-diphenylamin-4-diazoniumsulfat mit 1 Mol 4,4'-Bis-methoxymethyl-diphenylether in 85 %iger Phosphorsäure und Isolieren als Mesitylensulfonat und

0,8 '' Viktoriareinblau FGA (C.I. Basic Blue 81)
0,5 '' Fhenylazodiphenylamin
1,2 '' Fhosphorsäure (85 %) in
900,0 '' Ethylenglykolmonomethylether.

Die Lösung wurde auf eine elektrochemisch aufgerauhte und anodisierte Aluminiumfolie, die mit Polyvinylphosphonsäure nachbehandelt worden war, aufgebracht.

Die Kopierschicht wurde unter einem Silberfilm-Halbtonstufenkeil mit dem Dichteumfang 0,05 bis 3,05, wobei die Dichteinkremente 0,15 betrugen, als Negativvorlage 20 Sekunden mit einer Metallhalogenid-Lampe von 5 kW Leistung belichtet.

Die belichtete Schicht wurde mit einer Entwicklerlösung folgender Zusammensetzung
5,0 Gew.-Teile Na-Laurylsulfat,
1,5 '' Na-Metasilikat,
1,5 '' Trinatriumphosphat,
92,0 '' entsalztes Wasser
mittels Plüschtampons behandelt, wobei die Nichtbildstellen entfernt wurden, mit Wasser abgespült und abgerakelt. In der Kopie war die Stufe 5 des Stufenkeils noch voll geschwärzt. Die erhaltene Druckplatte lieferte an einer Bogenoffsetmaschine eine Auflage von 70 000 Bögen.

**Beispiele 2 - 5**

Wird das Bindemittel in Beispiel 1 durch folgende StyrolMaleinsäurederivat-Folymerisate ausgetauscht, werden ähnliche Ergebnisse erhalten.

**Beispiel 2**

Ein Styrol-Maleinsäureester-Copolymeres mit dem Erweichungspunkt 140 - 160°C und einer Säurezahl von 145160.

**Beispiel 3**

Ein Styrol-Maleinsäureanhydrid-Copolymeres, dessen Anhydridgruppen mit einem niedermolekularen Alkohol umgesetzt wurden, Erweichungspunkt 217 - 225°C, Säurezahl 200 - 220, durchschnittliches Molekulargewicht ca. 20 000.

**Beispiel 4**

Ein Styrol-Maleinsäureanhydrid-Copolymeres mit einem Erweichungspunkt von 205 - 220°C, Säurezahl ca. 300, durchschnittliches Molekulargewicht ca. 50 000.

## Beispiel 5

Ein Styrol-Maleinsäureanhydrid-Copolymeres, dessen Anhydridgruppen mit einem niedermolekularen Alkohol umgesetzt wurden, Erweichungspunkt 190 - 205°C, Säurezahl ca. 200, durchschnittliches Molekulargewicht ca. 10 000.

## Beispiel 6

Eine Beschichtungslösung wurde aus folgenden Komponenten hergestellt:
15,0 Gew.-Teilen des Bindemittels aus Beispiel 5,
15,0 ' ' des Diazopolykondensats aus Beispiel 1,
0,8 ' ' Viktoriareinblau FGA,
0,5 ' ' Fhenylazodiphenylamin,
2,0 ' ' Fhosphorsäure (85 %) in
950,0 ' ' Ethylenglykolmonomethylether.
Die Lösung wurde auf eine elektrochemisch aufgerauhte und anodisierte Aluminiumfolie, die mit Folyvinylphosphonsäure nachbehandelt worden war, in einer Schichtstärke von ca. 1,0 g/m² aufgebracht.
Die Kopierschicht wurde unter einer Negativvorlage 22 Sekunden belichtet.
Nach Entwicklung mit dem Entwickler aus Beispiel 1 wurde die Platte in eine Kleinoffsetmaschine gespannt, wo eine Druckauflage von über 100 000 Bögen erhalten wurde.

## Beispiel 7

Anstelle des in Beispiel 6 angegebenen Bindemittels wurde das Bindemittel aus Beispiel 3 eingesetzt, wobei ähnliche Ergebnisse erhalten wurden.

## Beispiel 8

Eine Beschichtungslösung wurde aus folgenden Komponenten hergestellt:
15,0 Gew.-Teile des Folymeren aus Beispiel 3,
15,0 ' ' eines Diazomischkondensats, hergestellt durch Kondensieren von 1 Mol 3-Methoxy-diphenylamin-4-diazoniumsulfat mit 1 Mol 4,4'-Bis-methoxymethyl-diphenylether in 85 %iger Fhosphorsäure und Isolieren als Methansulfonat,
1,6 ' ' Rhodamin 6 GDN (C.I. 45160),
2,0 ' ' Fhosphorsäure (85 %ig),
966,4 ' ' Ethylenglykolmonomethylether.
Die Lösung wurde auf eine elektrochemisch aufgerauhte und anodisierte Aluminiumfolie, die mit Folyvinylphosphonsäure nachbehandelt worden war, aufgebracht.
Die Kopierschicht wurde unter einer Negativvorlage 35 Sekunden lang mit einer Metallhalogenid-Lampe von 5 kW Leistung belichtet.
Die belichtete Schicht wurde mit der Entwicklerlösung aus Beispiel 1 in der üblichen Weise behandelt. Dabei wurde eine einwandfreie Druckplatte erhalten, die in einer Bogenoffsetmaschine eine hohe Druckauflage erbrachte.

## Patentansprüche.

1. Verfahren zur Herstellung einer Flachdruckform, bei dem ein lichtempfindliches Kopiermaterial aus einem zum Flachdruck geeigneten Schichtträger mit hydrophiler Oberfläche und einer negativ arbeitenden lichtempfindlichen Schicht, die als lichtempfindliche Verbindung ein Kondensationsprodukt aus wiederkehrenden Einheiten $A-N_2X$ und B enthält, die durch zweibindige, von einer kondensationsfähigen Carbonylverbindung abgeleitete Zwischenglieder verbunden sind, wobei die Einheiten $A-N_2X$ sich aus Verbindungen der allgemeinen Formel
$(R^1-R^3-) R^2-N_2X$
ableiten und wobei
X das Anion der Diazoniumverbindung,
p eine ganze Zahl von 1 bis 3,
$R^1$ einen carbocyclischen oder heterocyclischen aromatischen Rest mit mindestens einer kondensationsfähigen Fosition,
$R^2$ eine Arylengruppe der Benzol- oder Naphthalinreihe, $R^3$ eine Einfachbindung oder eine der Gruppen:
$-(CH_2) -NR^4-$,
$-0-(CH2)r-NR^4-$,
$-S-(CH_2)_r-NR^4-$,
$-S-CH_2-CO-NR^4-$,
$-0-R5-0-$,
$- 0 -$,
$- S -$ oder
$-CO-NR^4$
bedeuten, worin
q eine Zahl von 0 bis 5,
r eine Zahl von 2 bis 5,
$R^4$ Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und
$R^5$ eine Arylengruppe mit 6 bis 12 C-Atomen ist, und
B den von Diazoniumgruppen freien Rest eines aromatischen Amins, Phenols, Thiophenols, Phenolethers, aromatischen Thioethers, aromatischen Kohlenwasserstoffs, einer aromatischen heterocyclischen Verbindung oder eines organischen Säureamids bedeutet,
wobei das Kondensationsprodukt im Mittel 0,01 bis 50 Einheiten B je Einheit $A-N_2X$ enthält,
und als einziges Bindemittel ein Copolymeres aus Styrol und Maleinsäureanhydrid oder einem Partialester der Maleinsäure enthält, bildmäßig belichtet wird und die nicht belichteten Schichtbereiche mit einem Entwickler ausgewäschen werden, dadurch gekennzeichnet, daß der Entwickler eine alkalische Lösung ist, die als Lösemittel ausschließlich Wasser enthält.

2. Verfahren nach Anspruch 1, dadurch gekennzeichnet, daß die als Entwickler dienende wäßrige Lösung einen pH-Wert von 8 bis 14 hat.

3. Verfahren nach Anspruch 1 oder 2, dadurch gekennzeichnet, daß das Diazoniumsalz-Polykondensationsprodukt in einer Menge von 5 bis 90 Gew.-% und das polymere Bindemittel in einer Menge von 10 bis 95 Gew.-%, bezogen auf das Gesamtgewicht der lichtempfindlichen Schicht, vorliegt.

**Claims**

1. Process for the production of a lithographic printing form, in which a light-sensitive reproduction material comprising a support which has a hydrophilic surface and is suitable for lithographic printing and a negative-working light-sensitive layer which contains as the light-sensitive compound a condensation product with recurrent units A-N₂X and B which are linked by bivalent intermediate members derived from a carbonyl compound which is capable of condensation, the units A-N₂X being derived from compounds of the general formula

(R¹-R³-) R²-N₂X

and with X standing for the anion of the diazonium compound,

p for an-integer from 1 to 3,

R¹ for a carbocyclic or heterocyclic aromatic radical which is capable of condensation in at least one position,

R² for an arylene group of the benzene or naphthalene series,

R³ for a single bond or one of the groups

-(CH₂) -NR⁴-,

-0-(CH₂)ᵣ-NR⁴-,

-S-(CH₂)ᵣ-NR⁴-,

-S-CH₂-CO-NR⁴-,

-0-R⁵-0

- 0 -,

- S - or

-CO-NR⁴

wherein q is a number from 0 to 5,

r is a number from 2 to 5,

R⁴ is a hydrogen atom, an alkyl group havingfrom 1 to 5 carbon atoms, an aralkyl group having from 7 to 12 carbon atoms or an aryl group having from 6 to 12 carbon atoms, and

R⁵ is an arylene group having from 6 to 12 carbon atoms,

and B denoting the radical of an aromatic amine, phenol, thiophenol, phenol ether, aromatic thioether, aromatic hydrocarbon,of an aromatic heterocyclic compound orof an organic acid amide, which is free of diazonium groups, the condensation product containing, on an average, from 0.01 to 50 B units for each A-N₂X unit, and as the sole binder a copolymer of styrene and maleic anhydride or a partial ester of maleic acid, is exposed imagewise and the unexposed layer areas are washed away with a developer, the process being characterized in that the developer used is an alkaline solution which contains exclusively water as the solvent.

2. A prosess as claimed in claim 1, wherein the aqueous solution serving as the developer has a pH value from 8 to 14.

3. A process as claimed in claim 1 or 2, wherein the diazonium salt polycondensation product is present in an amount from 5 to 90 percent by weight and the polymeric binder is present in an amount from 10 to 95 percent by weight, relative to the total weight of the light-sensitive layer.

**Revendications**

1. Procédé pour la préparation d'une forme d'impression planographique, dans lequel un matériaude copie photosensible constitué d'un support de couche approprié pour l'impression planographique, à surface hydrophile, et d'une couche photosensible opérant en négatif qui contient en tant que composé photosensible un produit de condensation d'unités répétitives A-N₂X et B qui sont reliées par des chainons intermédiaires divalents dérivant d'un compose carbonyle capable d'une condensation, les unites A-K₂X derivant de composes de formule generale

(R¹ R³- R²-N₂X

X représentant l'anion du composé diazonium,

p étant un nombre entier allant de 1 à 3,

R¹ représentant un radical aromatique carbocyclique ou hétérocyclique ayant au moins une position capable de condensation,

R² représentant un groupe arylène de la série du benzene ou de celle du naphtalène,

R³ étant une simple liaison ou l'un des groupes:

-(CH₂)q-NR⁴-,

-0-(CH₂)ᵣ-NR⁴-,

-S-(CH₂)ᵣ-NR⁴-,

-S-(CH₂)ᵣ-NR⁴-,

-0-,

-S- ou

-CO-NR⁴

dans lesquels

q est un nombre allant de 0 à 5,

r est un nombre allant de 2 à 5,

R⁴ est un atome d'hydrogene, un groupe alkyle ayantde 1 à 5 atomes de carbone, un groupe aralkyle ayant de 7 à 12 atomes de carbone ou un groupe aryle ayant de 6 à 12 atomes de carbone, et

R⁵ est un groupe aryléne ayant de 6 à 12 atomes de carbone, et

B représentant le reste exempt de groupes diazonium d'une amine aromatique, d'un phénol, d'un thiophénol, d'un éther phénolique, d'un thio-éther aromatique, d'un hydrocarbure aromatique, d'un composé hétérocyclique aromatique ou d'un amide d'acide organique.

le produit de condensation contenant en moyenne 0,01 à 50 unités B pour chaque unité A-

$N_2X$,

et qui contient en tant que liant unique un copolymére de styrene et d'anhydride d'acide maléique ou d'un ester partiel de l'acide maléique,

est exposé selon l'image et les zones de la couche non exposees sont éliminées par lavage avec un rélévateur caractérisé par le fait que le révélateur est une solution alcaline qui contient comme solvant exclusivement de l'eau.

2. Procédé selon la revendication 1, caractérisé par le fait que la solution aqueuse servant de relévateur a un pH de 8 à 14.

3. Procédé selon la revendication 1 ou 2, caractérisé par le fait que le produit de polycondensation de sels de diazonium est présent en une quantité allant de 5 à 90% en poids et que le liant polymère est présent en une quantité allant de 10 à 95% en poids, rapportées au poids total de la couche photosensible.